# FASCICULE DE BREVET EUROPEEN

(11) **EP 3 748 352 B1**
(45) Date de publication et mention de la délivrance du brevet: **14.12.2022**
(21) Numéro de dépôt: 20178063.2
(22) Date de dépôt: 03.06.2020
(51) Int. Cl.: G01N 29/02, G01N 29/24

(54) **PROCÉDÉ DE FABRICATION D'UNE PLURALITÉ DE RÉSONATEURS**
HERSTELLUNGSVERFAHREN EINER VIELZAHL VON RESONATOREN
METHOD FOR MANUFACTURING A PLURALITY OF RESONATORS

(30) Priorité: 07.06.2019 FR 1906057
(43) Date de publication de la demande: 09.12.2020
(73) Titulaire: Commissariat à l'énergie atomique et aux énergies alternatives, 75015 Paris (FR)
(72) Inventeur: FAIN, Bruno, 38054 GRENOBLE CEDEX 09 (FR); COUTIER, Caroline, 38054 GRENOBLE CEDEX 09 (FR)
(74) Mandataire: Brevalex

(56) Documents cités:
- EP-A1- 2 152 024
- EP-A1- 3 424 603
- WO-A1-2010/073534
- US-A1- 2013 128 702
- US-A1- 2017 245 035

## Description

### DOMAINE TECHNIQUE

La présente invention se rapporte au domaine des micros systèmes électromécaniques. Les micros systèmes électromécaniques couverts par la présente invention peuvent notamment comprendre des capteurs pour l'émission et/ou la réception acoustique et présentant une sensibilité améliorée au regard des capteurs connue de l'état de la technique.

La présente invention concerne également des capteurs de gaz.

En particulier, la présente invention concerne un procédé de fabrication, de manière collective, d'une pluralité de résonateurs, par exemple des résonateurs destinés à l'émission / réception d'ultrasons ou destinés à la détection de gaz, encore plus particulièrement à la détection de gaz par mesure gravimétrique.

Le procédé selon la présente invention propose d'exclure une partie des résonateurs formés de manière à améliorer le facteur de qualité du détecteur formé par les résonateurs restants.

### ÉTAT DE LA TECHNIQUE ANTÉRIEURE

L'avènement des techniques de micro fabrication a permis l'essor des micros systèmes électromécaniques (« MEMS » ou « Micro Electro Mechanical System » selon la terminologie Anglo-Saxonne).

Parmi ces derniers, les résonateurs, formés par une membrane en recouvrement d'une cavité, sont mis en œuvre dans bon nombre d'applications et notamment dans les capteurs, et plus particulièrement les capteurs de gaz par mesure gravimétrique tel que décrit dans le document [1] cité à la fin de la description.

Ces membranes susceptibles de vibrer selon une direction perpendiculaire au plan formé par lesdites membranes sont caractérisées par leur fréquence de résonance (aussi associée à la fréquence de résonance des capteurs).

Le fonctionnement de ces capteurs, décrit dans le document [2] cité à la fin de la description, est basé sur le décalage de la fréquence de résonnance de leur résonateur induit, par exemple, par l'adsorption d'espèces chimiques sur une face de ladite membrane.

La sensibilité d'un tel capteur pourvu d'un unique résonateur, régie par le facteur de qualité dudit résonateur, reste toutefois limitée, de sorte que la détection de quantités infinitésimales de gaz reste difficile, voire impossible.

Afin d'améliorer la sensibilité, et donc les performances du capteur de gaz, il été proposé de doter ce dernier d'une pluralité de résonateurs agencés par exemple sous forme matricielle.

Les techniques de micro fabrication permettent, à cet égard, d'envisager la fabrication, de manière collective, de plusieurs centaines, voire de plusieurs milliers, de résonateurs destinés à détecter en parallèle, au sein d'un même capteur, un gaz donné.

Cependant, cette solution, considérée sans autres précautions, ne permet pas de répondre favorablement à la problématique relative à la sensibilité d'un capteur.

Les documents EP 2 152 024, US 2017/245035 et EP 3 424 603 divulguent chacun un dispositif pourvu d'une membrane suspendue sans toutefois répondre favorablement aux problématiques décrites ci-avant.

Un but de la présente invention est donc de proposer un procédé de formation d'une pluralité de résonateurs qui pris collectivement présentent un facteur de qualité amélioré.

Un autre but de la présente invention est de proposer un procédé de formation d'une pluralité de résonateurs et dont la dispersion en termes de fréquences de résonance est réduite par rapport aux capteurs connus de l'état de la technique.

### EXPOSÉ DE L'INVENTION

Le but de la présente invention est atteint par un procédé de fabrication d'une pluralité de résonateurs, formés chacun par une membrane scellant une cavité, le procédé comprend :
a) une étape de formation d'une pluralité de cavités, avantageusement identiques, à partir d'une face, dite face avant, d'un substrat support, la pluralité de cavités comprend des cavités centrales et des cavités périphériques disposées autour de l'ensemble formé par les cavités centrales ;
b) une étape de formation de membranes, dites respectivement, centrales et de membranes périphériques en recouvrement, respectivement, des cavités centrales et des cavités périphériques, par report d'un film de recouvrement sur la face avant du substrat support ;
c) une étape de retrait d'au moins une partie des membranes périphériques.

Selon un mode de mise en œuvre, l'étape c) comprend une gravure localisée du film de recouvrement, la gravure localisée comprend notamment une gravure humide ou une gravure sèche.

Selon un mode de mise en œuvre, les cavités sont agencées de manière matricielle.

Selon un mode de mise en œuvre, les cavités sont de forme carrée, ou de rectangle, ou de polygone, ou de disque.

Selon un mode de mise en œuvre, l'intégralité des membranes périphériques est retirée lors de l'étape c).

Selon un mode de mise en œuvre, les membranes périphériques comprennent les membranes en bord de l'agencement matriciel.

Selon un mode de mise en œuvre, les membranes périphériques forment un contour de plusieurs membranes de même largeur.

Selon un mode de mise en œuvre, l'étape c) comprend le retrait des membranes périphériques en recouvrement des cavités périphériques au niveau des coins de l'agencement matriciel.

Selon un mode de mise en œuvre, une électrode métallique commune à toutes les membranes centrales est formée en recouvrement desdits membranes centrales.

Selon un mode de mise en œuvre, l'étape b) comprend une étape b1) de collage d'un substrat, dit substrat donneur, sur la face avant, et une étape b2) de retrait d'une première partie du substrat donneur de manière à ne conserver qu'une seconde partie dudit substrat formant le film de recouvrement.

Selon un mode de mise en œuvre, l'étape b1) est précédée d'une étape de formation d'une zone de fragilisation séparant la première partie de la seconde partie, et au niveau de laquelle une fracture du substrat est susceptible de se produire, lors de l'exécution de l'étape b2), sous l'effet d'un traitement thermique et/ou d'une action mécanique.

Selon un mode de mise en œuvre, l'étape b2) est une étape d'amincissement mécanique, notamment une étape d'amincissement mécanique par abrasion suivie d'une gravure humide.

Selon un mode de mise en œuvre, la première partie et la seconde partie sont séparées par une couche d'arrêt au niveau de laquelle la gravure humide de l'étape b2) s'arrête.

Selon un mode de mise en œuvre, l'étape a) comprend une gravure sèche ou humique du substrat support.

Selon un mode de mise en œuvre, les cavités ont une forme essentiellement carrée.

Selon un mode de mise en œuvre, le film de recouvrement comprend un matériau semi-conducteur, avantageusement du silicium.

### BRÈVE DESCRIPTION DES DESSINS

D'autres caractéristiques et avantages apparaîtront dans la description qui va suivre d'un procédé de fabrication d'une pluralité de résonateurs, donnés à titre d'exemples non limitatifs, en référence aux dessins annexés dans lesquels :
Les figures 1a, 1b et 1c sont des représentations schématiques illustrant des étapes de fabrication a) et b) susceptibles d'être mises en œuvre dans le cadre de la présente invention ;
Les figures 2a, 2b et 2c sont des représentations schématiques illustrant un autre mode de mise œuvre de l'étape de fabrication b) susceptible d'être mise en œuvre dans le cadre de la présente invention ;
Les figures 3a, 3b, 3c, 3d, 3e, 3f, 3g, 3h, 3i et 3j sont des représentations schématiques d'un ensemble d'étapes de fabrication impliquant le procédé selon la présente invention, et susceptibles de mener à la fabrication d'un capteur ;
La figure 4 est représentation d'un agencement matriciel de cavités ;
Les figures 5a, 5b, 5c et 5d sont des représentations de différentes variantes de la présente invention, les membranes blanches sont les membranes conservées, les membranes noires sont les membranes gravées, et les membranes hachurées sont des membranes périphériques non gravées.

### EXPOSÉ DÉTAILLÉ DE MODES DE RÉALISATION PARTICULIERS

La présente invention concerne un procédé de fabrication de résonateurs formés par des membranes en recouvrement de cavités.

En particulier, la présente invention concerne un procédé de fabrication de résonateurs destinés à fonctionner en parallèle dans un capteur et présentant collectivement une sensibilité accrue par rapport aux capteurs pourvus également d'une pluralité de résonateurs, et connus de l'état de la technique.

À cet égard, le procédé de fabrication selon la présente invention prévoit la formation d'une pluralité de résonateurs, agencés par exemple de manière matricielle, suivi d'un retrait ou d'une gravure des membranes des résonateurs périphériques.

Un résonateur, selon la présente invention, comprend une membrane en suspension au-dessus d'une cavité. En particulier, la membrane peut être formée par une couche, dite couche de recouvrement, formée sur ladite cavité. Une couche de recouvrement formée sur une pluralité de cavité forme ainsi une pluralité de membranes en suspension au-dessus desdites cavités.

Les figures la-lc, 2a-2c, et 3a-3j illustrent les différentes étapes du procédé de fabrication de résonateurs selon la présente invention.

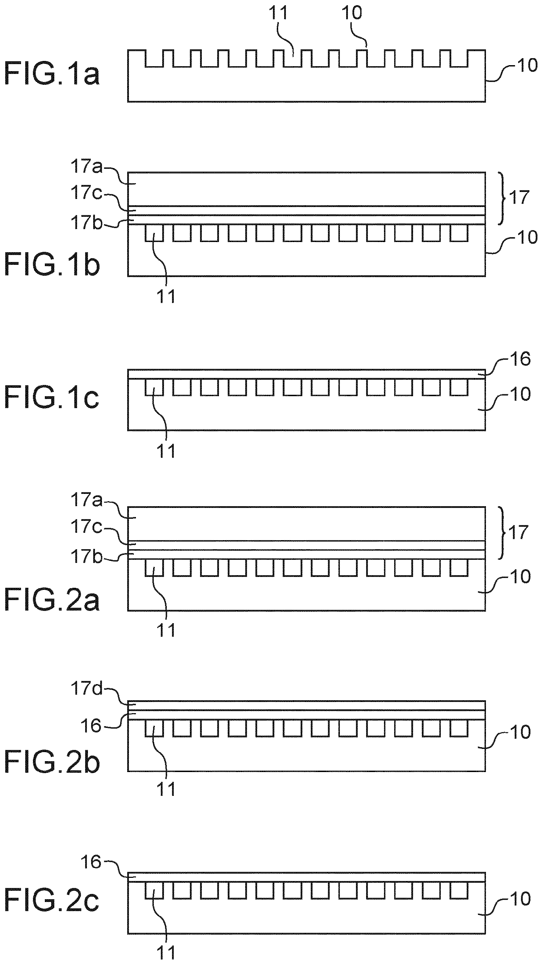

Le procédé comprend notamment une étape a) de formation d'une pluralité de cavités 11 débouchant au niveau d'une face avant d'un substrat support 10 (figure 1a).

Le substrat support 10 peut comprendre un matériau semi-conducteur, et notamment du silicium.

L'étape a) peut notamment comprendre une étape de masquage permettant de délimiter le contour des cavités 11, et une étape de gravure.

L'étape de masquage peut impliquer la formation d'un masque dur (« hard mask » selon la terminologie Anglo-Saxonne), et notamment un masque de dioxyde de silicium.

L'étape de gravure peut comprendre une gravure sèche (par exemple une gravure impliquant un plasma) ou une gravure humide.

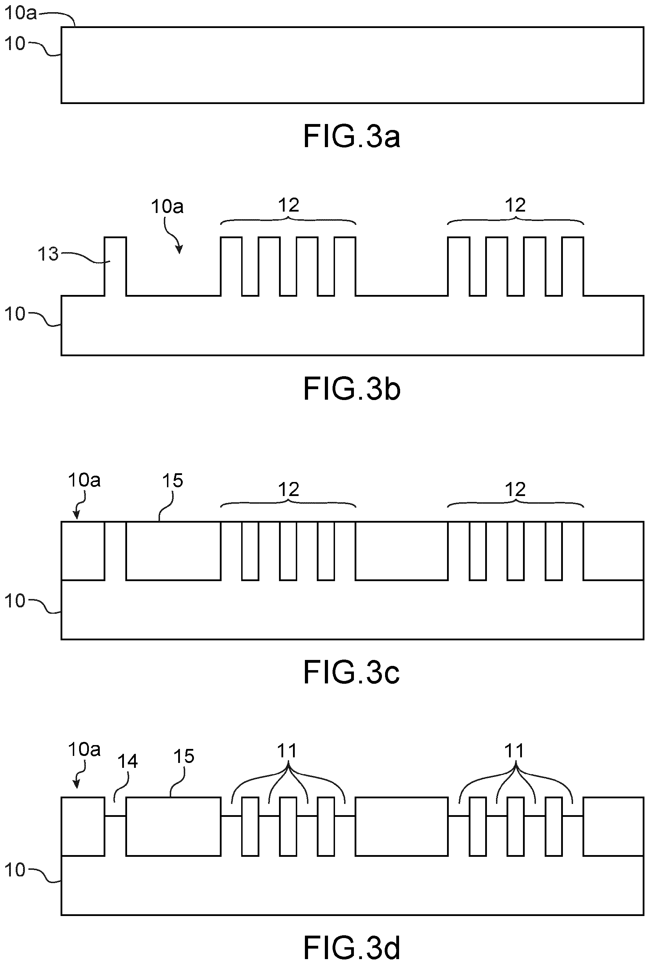

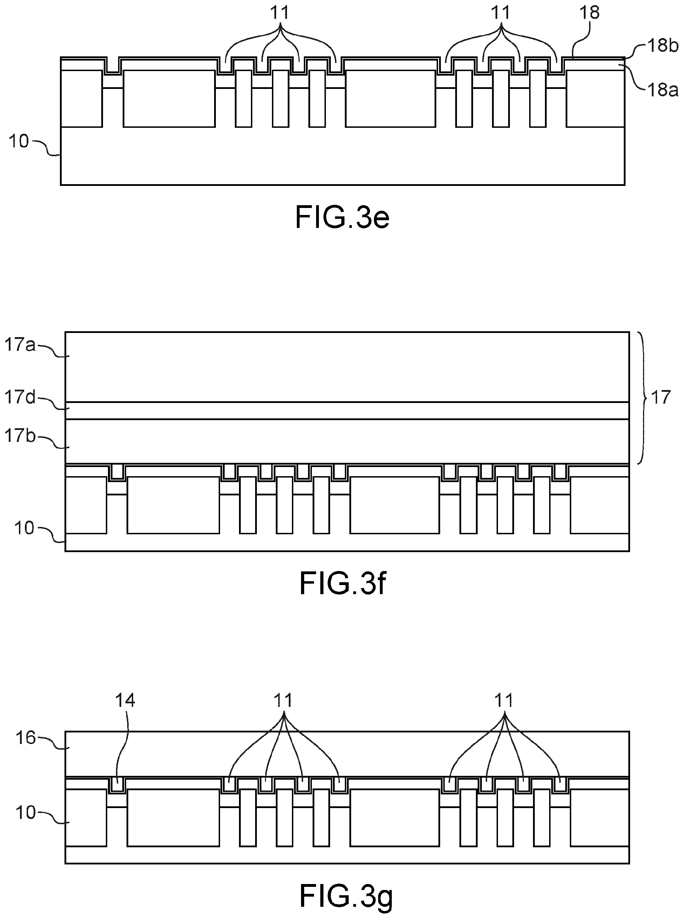

À titre d'exemple non limitatif, l'étape a) peut comprendre les étapes suivantes :
a1) une étape de fourniture d'un substrat support 10, notamment un substrat de silicium (figure 3a) ;
a2) une étape formation de premiers motifs 12 en projection par rapport à une face avant 10a du substrat support, les premiers motifs 12, et des seconds motifs 13, définissant notamment des colonnes de forme carrée ou rectangulaire au niveau desquelles seront formées, respectivement les cavités 11, et des contacts 14a (figure 3b).

Cette étape a2) peut comprendre, et dans l'ordre, une étape de photolithographie, une étape de gravure. Les premiers 12 et les seconds 13 motifs peuvent par exemple être d'une hauteur comprise entre 500 nm et 2 µm.

Toujours selon cet exemple, l'étape a) peut également comprendre une étape de a3) de remplissage par un matériau diélectrique 15 du volume entre les premiers motifs 12 et les seconds motifs 13 (figure 3c). Le matériau diélectrique 15 peut notamment comprendre du dioxyde de silicium déposé par une technique de dépôt chimique en phase vapeur assistée par plasma (« PECVD » ou « Plasma Enhanced Chemical Vapor Déposition » selon la terminologie Anglo-Saxonne).

Il est entendu que le remplissage est exécuté de manière à laisser exposés à l'environnement extérieur les sommets des premiers motifs 12 et des seconds motifs 13. En d'autres termes, tout excès de matériau diélectrique 15, par exemple déposé sur les sommets des premiers motifs 12 et des seconds motifs 13, peut être retiré par un procédé de polissage, et notamment un polissage mécano-chimique.

L'étape a3) peut être suivie d'une étape a4) de gravure partielle des premiers motifs 12 et des seconds motifs 13 de manière à former, respectivement, les cavités 11 et des zones de contact 14 (figure 3d).

La profondeur des cavités 11 (et des zones de contact 14) ainsi formées peut être comprise entre 50 nm et 1000 nm.

La forme des cavités 11, tel que précisé précédemment, est définie par la forme des premiers motifs 12.

Les techniques de micro fabrication (ou étapes technologiques) citées ci-avant permettent de considérer la formation, de manière collective, d'un très grand nombre de cavités, et notamment plusieurs centaines, voire plusieurs milliers, de cavités identiques.

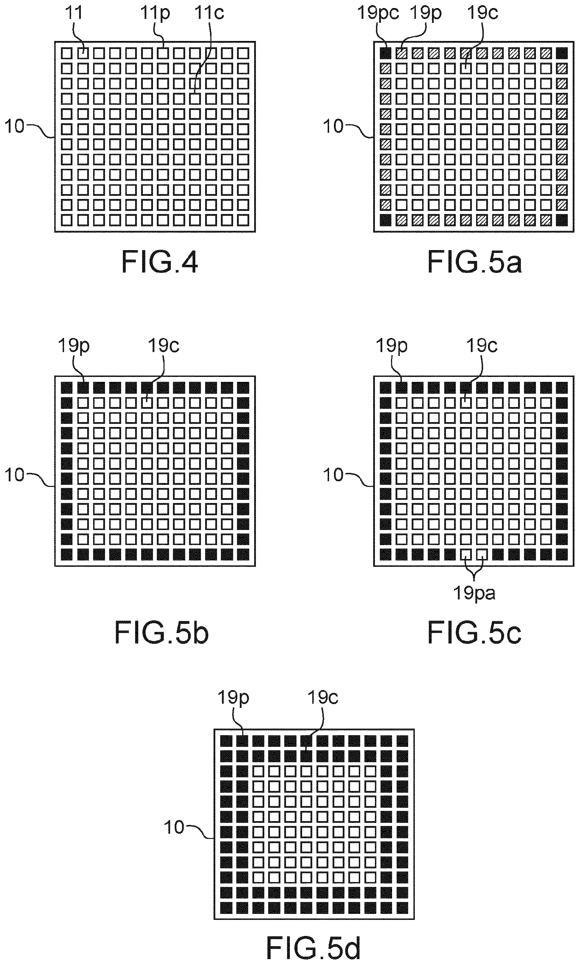

Ainsi, et de manière non limitative, les cavités 11 peuvent être agencées de manière matricielle (figure 4).

Par « agencement matriciel », on entend un agencement périodique et régulier selon deux directions orthogonales de cavités 11. L'agencement matriciel comprend notamment n lignes et m colonnes des cavités 11.

La suite de l'énoncé de la présente invention se limitera pour souci de simplification à un agencement matriciel des cavités. L'homme du métier pourra toutefois généraliser l'invention à d'autres agencements.

Le procédé selon la présente invention comprend également une étape b) de formation de membranes.

L'étape b) de formation de membranes 19 comprend notamment le report d'un film de recouvrement 16 sur la face avant du substrat support 10.

Les membranes 19 sont en suspension au-dessus des cavités 11.

Le report du film de recouvrement peut notamment impliquer une étape b1) de collage d'un substrat, dit substrat donneur 17, sur la face avant 11a, et une étape b2) de retrait d'une première partie 17a du substrat donneur 17 de manière à ne conserver qu'une seconde partie 17a dudit substrat formant le film de recouvrement 16 (figure 1b, 1c, 2a, 2b, 2c, 3f et 3g).

Il est entendu que l'étape b1) de collage peut comprendre un collage moléculaire (ou direct), un collage par thermocompression.

L'invention ne doit toutefois pas être limitée à ces deux types de collage, et peut notamment comprendre un collage impliquant une couche intermédiaire de collage (par exemple un matériau polymère), un collage anodique, un collage eutectique.

L'étape de collage b1) peut également être exécutée sous vide ou sous une atmosphère contrôlée notamment pour imposer un gaz et une pression prédéterminées dans les cavités 11 scellées par le film de recouvrement 16.

Par ailleurs, il est entendu sans qu'il soit nécessaire de le préciser que le scellement des cavités par le film de recouvrement est hermétique.

Par « scellement hermétique », on entend un scellement qui prévient les échanges gazeux entre les cavités considérées et l'environnement extérieur.

L'étape b1) peut être précédée d'une étape de formation d'une zone de fragilisation 17c séparant la première partie 17a de la seconde partie 17b, et au niveau de laquelle une fracture du substrat donneur 17 est susceptible de se produire, lors de l'exécution de l'étape b2), sous l'effet d'un traitement thermique et/ou d'une action mécanique.

La zone de fragilisation 17c peut être une zone amorphisée ou une zone implantée, notamment une zone implantée avec des atomes d'hydrogène.

De manière alternative et en l'absence de zone de fragilisation 17c, l'étape b2) peut comprendre une étape d'amincissement mécanique (figures 2a à 2c), et notamment une étape d'amincissement mécanique par abrasion (« Grinding » selon la terminologie Anglo-Saxonne) éventuellement complétée par une gravure chimique.

Toujours selon cette alternative, la première partie 17a et la seconde partie 17b sont séparées par une couche d'arrêt 17d au niveau de laquelle la gravure chimique de l'étape b2) s'arrête. En d'autres termes, la gravure chimique est une gravure sélective, et grave préférentiellement le la première partie 17a au regard de la couche d'arrêt 17d.

Le substrat donneur 17, selon cette alternative, peut notamment être un substrat de silicium sur isolant (« SOI »), la couche d'isolant étant la couche d'arrêt. La couche de silicium du substrat SOI est avantageusement fortement dopée. La couche d'arrêt peut être gravée par abrasion ou par une étape de gravure chimique sélective.

L'étape b) peut être précédée d'une étape de dépôt d'une couche de passivation en recouvrement de la face avant 10a (figure 3e). La couche de passivation 18 peut notamment comprendre un premier dépôt d'une couche de nitrure de silicium 18a par suivie d'un second dépôt d'une couche de dioxyde de silicium 18b.

L'épaisseur de chacune de ces deux couches 18a et 18b peut être comprise entre 30 nm et 300 nm.

La première couche 18a peut être formée par dépôt chimique en phase vapeur à basse pression (« LPCVD » ou « Low Pressure Chemical Vapor Déposition » selon la terminologie Anglo-Saxonne).

La seconde couche 18b peut être formée par dépôt chimique en phase vapeur assistée par plasma.

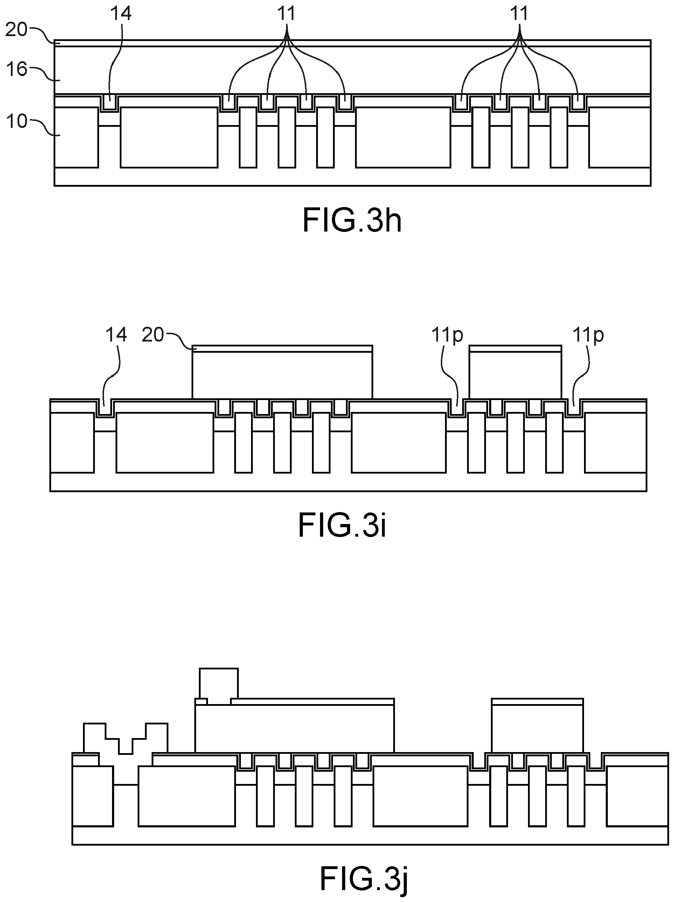

L'étape b) peut également être suivie d'une étape de dépôt d'une couche de passivation 20 sur le film de recouvrement (figure 3h). La couche de passivation 20 peut comprendre une couche de nitrure de silicium de 50 nm d'épaisseur, et formée par LPCVD.

Selon la présente invention, une distinction est faite entre des résonateurs centraux, formés par des cavités centrales 11c et des membranes centrales 19c d'une part, et des résonateurs périphériques, formés par des cavités périphériques 11p et des membranes périphériques 19p d'autre part.

Les résonateurs périphériques sont disposés autour de l'ensemble formé par les résonateurs centraux.

Par « disposés autour », on entend formant un chemin fermé autour des résonateurs centraux.

Selon un premier aspect de la présente invention, les membranes périphériques 19p peuvent comprendre les membranes en bord de l'agencement matriciel (figure 5b).

Selon un second aspect, les membranes périphériques 19p forment un contour de plusieurs membranes de largeur (figure 5d).

Ainsi, selon la présente invention, les membranes périphériques sont, au moins en partie retirées lors d'une étape c) de retrait exécutée après l'étape b).

L'étape c) peut comprendre une gravure localisée du film de recouvrement, la gravure localisée comprend notamment une gravure humide ou une gravure sèche.

Selon une première variante (illustrée à la figure 5a), seules les membranes périphériques 19p (notées 19pc sur la figure 5a) en recouvrement des cavités périphériques 11p au niveau des coins de l'agencement matriciel sont retirées.

Selon une seconde variante (illustrée à la figure 5b), l'intégralité des membranes périphériques 19p est retirée lors de l'étape c). Selon cette variante, il peut être considéré de conserver au moins deux membranes périphériques adjacentes notées 19pa (figure 5c).

L'étape c) de retrait des membranes périphériques est également illustrée à la figure 3i. Ce retrait peut notamment intervenir lors d'une étape de gravure localisée de la couche de passivation 20, et du film de recouvrement 16 destinée à donner accès aux zones de contact 14.

Une étape de prise de contact peut finalement être exécutée (figure 3j) au niveau de la zone de contact 14, et au niveau des membranes centrales.

Cette étape peut notamment impliquer la formation d'ouvertures dans les couches de passivation 18 et 20, et la formation de contacts 14a et 21, notamment en déposant de l'aluminure de silicium par dépôt physique en phase vapeur.

Les contacts 14 peuvent contacter l'intégralité ou une partie des membranes 19. L'ensemble des membranes 19 peut être pourvu d'un ou plusieurs groupes de membranes 19, les contacts 14 des membranes 19 d'un groupement donné formant une électrode commune.

Les contacts 14, dès qu'ils forment une électrode commune, peuvent être agencés selon des lignes, des spirales. Toutefois, l'invention n'est pas limitée à ces seules configurations.

Le procédé de fabrication d'une pluralité de résonateurs selon la présente invention, et notamment le retrait d'au moins une partie des membranes périphériques, permet d'accroitre le facteur de qualité du résonateur.

En effet, sans être liés par le raisonnement qui suit, les inventeurs pensent que l'environnement immédiat des membranes peut avoir une influence sur les contraintes subies par ces dernières.

En particulier, les inventeurs sont d'avis que, notamment lors de l'exécution de l'étape de collage, la pression dans les cavités est différente d'une cavité à l'autre et induit par conséquent une déflection des membranes d'un résonateur à l'autre. Cette différence est notamment plus marquée entre les cavités centrales et les cavités périphériques.

En d'autres termes, les membranes périphériques, telles que définies dans la présente invention, et plus particulièrement les plus à proximité du bord de la pluralité de membranes sont soumises à des contraintes (par exemple dues à la pression interne de la cavité) très différentes de celles subies par les membranes centrales.

Les résonateurs centraux forment quant à eux un ensemble plus homogène en termes de contraintes subies, et présentent, par conséquent, de manière collective un facteur de qualité supérieur au facteur de qualité du même ensemble et pour lequel l'intégralité des membranes centrales et périphériques est conservée.

L'amélioration du facteur de qualité permet alors de considérer la fabrication de capteurs de gaz par mesure gravimétrique présentant une meilleure sensibilité.

De tels capteurs peuvent notamment être mis en œuvre comme capteurs d'odeurs ou encore pour la spectroscopie de masse.

En particulier, le capteur peut comprendre un micro-transducteur ultrason capacitif (« cMUT » ou « capacitive micromachined ultrasound transducer » selon la terminologie Anglo-Saxonne).

### REFERENCES

[1] Hyunjoo J. Lee et al., «CMUT as a Chemical Sensor for DMMP Detection», IEEE, 2008, pages 434-439.
[2] S. Fanget et al., «Gas sensors based on gravimetric detection-A review», Sensors and Actuators B, 160, 804-821, 2011.

## Revendications

1. Procédé de fabrication d'une pluralité de résonateurs, formés chacun par une membrane scellant une cavité, le procédé comprend :
a) une étape de formation d'une pluralité de cavités (11), avantageusement identiques, à partir d'une face, dite face avant (10a), d'un substrat support (10), la pluralité de cavités comprend des cavités centrales (11c) et des cavités périphériques (11p) disposées autour de l'ensemble formé par les cavités centrales (11c) ;
b) une étape de formation de membranes (19), dites respectivement, centrales (19c) et de membranes périphériques (19p) en recouvrement, respectivement, des cavités centrales (11c) et des cavités périphériques (11p), par report d'un film de recouvrement (16) sur la face avant du substrat support ; ledit procédé étant **caractérisé en ce qu'**il comprend:
c) une étape de retrait d'au moins une partie des membranes périphériques (19p).

2. Procédé selon la revendication 1, dans lequel l'étape c) comprend une gravure localisée du film de recouvrement, la gravure localisée comprend notamment une gravure humide ou une gravure sèche.

3. Procédé selon la revendication 1 ou 2, dans lequel les cavités (11) sont agencées de manière matricielle.

4. Procédé selon la revendication 3, dans lequel l'intégralité des membranes périphériques (19p) est retirée lors de l'étape c).

5. Procédé selon la revendication 3 ou 4, dans lequel les membranes périphériques (19p) comprennent les membranes (19) en bord de l'agencement matriciel.

6. Procédé selon la revendication 3 ou 4, dans lequel les membranes périphériques (19p) forment un contour de plusieurs membranes de largeur.

7. Procédé selon la revendication 3, dans lequel l'étape c) comprend le retrait des membranes périphériques (19p) en recouvrement des cavités périphériques (11p) au niveau des coins de l'agencement matriciel.

8. Procédé selon l'une des revendications 1 à 7, dans lequel une électrode métallique commune à toutes les membranes centrales est formée en recouvrement desdits membranes centrales (19c).

9. Procédé selon l'une des revendications 1 à 8, dans lequel l'étape b) comprend une étape b1) de collage d'un substrat, dit substrat donneur (17), sur la face avant (11a), et une étape b2) de retrait d'une première partie (17a) du substrat donneur (17) de manière à ne conserver qu'une seconde partie (17b) dudit substrat formant le film de recouvrement.

10. Procédé selon la revendication 9, dans lequel l'étape b1) est précédée d'une étape de formation d'une zone de fragilisation (17c) séparant la première partie (17a) de la seconde partie (17b), et au niveau de laquelle une fracture du substrat est susceptible de se produire, lors de l'exécution de l'étape b2), sous l'effet d'un traitement thermique et/ou d'une action mécanique.

11. Procédé selon la revendication 9, dans lequel l'étape b2) est une étape d'amincissement mécanique, notamment une étape d'amincissement mécanique par abrasion suivie d'une gravure humide.

12. Procédé selon la revendication 11, dans lequel la première partie (17a) et la seconde partie (17b) sont séparées par une couche d'arrêt (17d) au niveau de laquelle la gravure humide de l'étape b2) s'arrête.

13. Procédé selon l'une des revendications 1 à 12, dans lequel l'étape a) comprend une gravure sèche ou humique du substrat support.

14. Procédé selon l'une des revendications 1 à 13, dans lequel les cavités (11) ont une forme essentiellement carrée.

15. Procédé selon l'une des revendications 1 à 14, dans lequel le film de recouvrement (16) comprend un matériau semi-conducteur, avantageusement du silicium.

## Patentansprüche

1. Verfahren zur Herstellung einer Vielzahl von Resonatoren, die jeweils durch eine Membran gebildet werden, die einen Hohlraum verschließt, wobei das Verfahren umfasst:
a) einen Schritt zum Bilden einer Vielzahl von, vorteilshalber identischen, Hohlräumen (11) aus einer Vorderseite (10a) genannten Seite eines Trägersubstrats (10), wobei die Vielzahl von Hohlräumen zentrale Hohlräume (11c) und periphere Hohlräume (11p) umfasst, die um die Einheit herum angeordnet sind, die durch die zentralen Hohlräume (11c) gebildet wird;
b) einen Schritt zum Bilden von Membranen (19), die jeweils zentrale (19c) und periphere Membranen (19p) genannt werden, jeweils in Überdeckung der zentralen Hohlräume (11c) und der peripheren Hohlräume (11p) durch Übertrag einer Überdeckungsfolie (16) auf die Vorderseite des Trägersubstrats,
wobei das Verfahren **dadurch gekennzeichnet ist, dass** es umfasst:
c) einen Schritt zum Abziehen mindestens eines Teils der peripheren Membranen (19p).

2. Verfahren nach Anspruch 1, wobei der Schritt c) ein lokalisiertes Ätzen der Überdeckungsfolie umfasst, wobei das lokalisierte Ätzen insbesondere Nassätzen oder Trockenätzen umfasst.

3. Verfahren nach Anspruch 1 oder 2, wobei die Hohlräume (11) in Form einer Matrix angeordnet sind.

4. Verfahren nach Anspruch 3, wobei im Schritt c) die Gesamtheit der peripheren Membranen (19p) abgezogen wird.

5. Verfahren nach Anspruch 3 oder 4, wobei die peripheren Membranen (19p) die Membranen (19) am Rande der Matrix-Anordnung umfassen.

6. Verfahren nach Anspruch 3 oder 4, wobei die peripheren Membranen (19p) eine Kontur aus mehreren Membranen in der Breite bilden.

7. Verfahren nach Anspruch 3, wobei der Schritt c) das Abziehen der peripheren Membranen (19p) in Überdeckung der peripheren Hohlräume (11p) im Bereich der Ecken der Matrix-Anordnung umfasst.

8. Verfahren nach einem der Ansprüche 1 bis 7, wobei eine allen zentralen Membranen gemeinsame metallische Elektrode in Überdeckung der zentralen Membranen (19c) gebildet wird.

9. Verfahren nach einem der Ansprüche 1 bis 8, wobei der Schritt b) einen Schritt b1) zum Kleben eines Donorsubstrat (17) genannten Substrats auf der Vorderseite (11a), und einen Schritt b2) zum Abziehen eines ersten Teils (17a) des Donorsubstrats (17) umfasst, um nur einen zweiten Teil (17b) des Substrats zu behalten, der die Überdeckungsfolie bildet.

10. Verfahren nach Anspruch 9, wobei dem Schritt b1) ein Schritt zum Bilden eines Schwächungsbereichs (17c) vorangeht, der den ersten Teil (17a) von dem zweiten Teil (17b) trennt, und im Bereich dessen bei Ausführung von Schritt b2) unter der Wirkung einer Wärmebehandlung und/oder einer mechanischen Aktion eine Fraktur des Substrats auftreten soll.

11. Verfahren nach Anspruch 9, wobei der Schritt b2) ein Schritt zur mechanischen Ausdünnung, insbesondere ein Schritt zur mechanischen Ausdünnung durch Abrasion, gefolgt von einer Nassätzung ist.

12. Verfahren nach Anspruch 11, wobei der erste Teil (17a) und der zweite Teil (17b) durch eine Stoppschicht (17d) getrennt sind, im Bereich derer die Nassätzung aus Schritt b2) gestoppt wird.

13. Verfahren nach einem der Ansprüche 1 bis 12, wobei der Schritt a) eine Trocken- oder Nassätzung des Trägersubstrats umfasst.

14. Verfahren nach einem der Ansprüche 1 bis 13, wobei die Hohlräume (11) eine im Wesentlichen quadratische Form aufweisen.

15. Verfahren nach einem der Ansprüche 1 bis 14, wobei die Überdeckungsfolie (16) ein Halbleitermaterial, vorzugsweise Silizium, umfasst.

## Claims

1. Method of manufacturing a plurality of resonators, each formed by a membrane sealing a cavity, the method comprises:
a) a step to form a plurality of cavities (11), advantageously identical, starting from one face called the front face (10a) of a support substrate (10), the plurality of cavities comprise central cavities (11c) and peripheral cavities (11p) arranged around the assembly formed by the central cavities (11c) ;
b) a step to form membranes (19), called central membranes (19c) and peripheral membranes (19p) respectively, covering central cavities (11c) and peripheral cavities (11p) respectively, by the transfer of a coverage film (16) on the front face of the support substrate; the method being **characterized in that** it comprises:
c) a step to remove at least part of the peripheral membranes (19p).

2. Method according to claim 1, wherein step c) comprises localised etching of the coverage film, the localised etching comprises in particular wet etching or dry etching.

3. Method according to any of claims 1 or 2, wherein the cavities (11) are arranged in matrix formation.

4. Method according to claim 3, wherein all peripheral membranes (19p) are removed during step c).

5. Method according to claim 3 or 4, wherein the peripheral membranes (19p) include the membranes (19) at the edge of the matrix arrangement.

6. Method according to claim 3 or 4, wherein the peripheral membranes (19p) form a contour with a width of several membranes.

7. Method according to claim 3, wherein step c) comprises the removal of peripheral membranes (19p) covering peripheral cavities (11p) at the corners of the matrix formation.

8. Method according to any of the claims 1 to 7, wherein a metallic electrode common to all central membranes is formed covering said central membranes (19c).

9. Method according to any of claims 1 to 8, wherein step b) comprises a step b1) to bond a substrate called the donor substrate (17), on the front face (11a), and a step b2) to remove a first part (17a) of the donor substrate (17) so as to keep only a second part (17b) of said substrate forming the coverage film.

10. Method according to claim 9, wherein step b1) is preceded by a step to form a zone of weakness (17c) separating the first part (17a) from the second part (17b), and at which a fracture of the substrate can occur, during execution of step b2), under the effect of a heat treatment and/or a mechanical action.

11. Method according to claim 9, wherein step b2) is a mechanical thinning step, particularly a mechanical thinning step by grinding followed by wet etching.

12. Method according to claim 11, where the first part (17a) and the second part (17b) are separated by a stop layer (17d) at which the wet etching of step b2) stops.

13. Method according to any of the claims 1 to 12, wherein step a) comprises dry or wet etching of the support substrate.

14. Device according to any of the claims 1 to 13, wherein the shape of the cavities (11) is essentially square.

15. Device according to any of the claims 1 to 14, wherein the coverage film (16) comprises a semiconducting material, advantageously silicon.
